(19) Europäisches Patentamt / European Patent Office / Office européen des brevets

(11) **EP 2 100 101 B1**

(12) **EUROPÄISCHE PATENTSCHRIFT**

(45) Veröffentlichungstag und Bekanntmachung des Hinweises auf die Patenterteilung:
**23.11.2016 Patentblatt 2016/47**

(21) Anmeldenummer: **07816219.5**

(22) Anmeldetag: **30.10.2007**

(51) Int Cl.:
**G01D 3/036** (2006.01)    **G01D 5/24** (2006.01)
**G01L 1/14** (2006.01)    **G01R 27/26** (2006.01)
**G06F 3/044** (2006.01)

(86) Internationale Anmeldenummer:
**PCT/CH2007/000536**

(87) Internationale Veröffentlichungsnummer:
**WO 2008/064500 (05.06.2008 Gazette 2008/23)**

(54) **ANORDNUNG ZUM MESSEN EINER PHYSIKALISCHEN GRÖSSE**

SYSTEM FOR MEASURING A PHYSICAL VARIABLE

SYSTÈME POUR MESURER UNE GRANDEUR PHYSIQUE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **01.12.2006 CH 19572006**

(43) Veröffentlichungstag der Anmeldung:
**16.09.2009 Patentblatt 2009/38**

(73) Patentinhaber: **Tecan Trading AG**
**8708 Männedorf (CH)**

(72) Erfinder:
• **KAMM, Lars**
**8874 Mühlehorn (CH)**
• **HINN, Werner**
**8712 Stäfa (CH)**
• **BAUMANN, Roman**
**8471 Bänk (Degerlen) (CH)**

(74) Vertreter: **OK pat AG**
**Industriestrasse 47**
**6300 Zug (CH)**

(56) Entgegenhaltungen:
**GB-A- 2 286 247    US-A- 5 936 412**

**Beschreibung**

Hinweis auf verwandte Anmeldungen

Diese Anmeldung beansprucht die Priorität der Schweizer Patentanmeldung Nr. 1957/06, die am 1. Dezember 2006 eingereicht wurde und deren ganze Offenbarung hiermit durch Bezug aufgenommen wird.

Technisches Gebiet

Die Erfindung betrifft eine Anordnung zum Messen einer physikalischen Grösse gemäss dem Oberbegriff des Anspruchs 1.

Stand der Technik

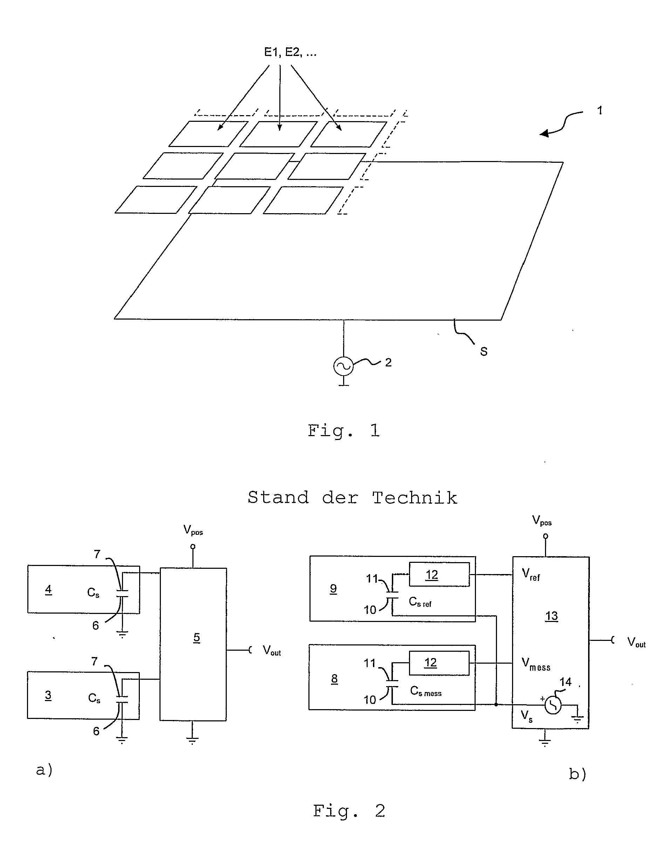

Zum Messen physikalischer Grössen, wie beispielsweise Druck, Füllzustand, Volumen oder der relativen Dielektrizitätszahl, werden häufig kapazitive Sensoren eingesetzt, die auf der Basis der Veränderung der Kapazität eines einzelnen Kondensators oder eines ganzen Kondensatorsystems durch die zu messende physikalische Grösse arbeiten. Durch Messung der Kapazität des Sensors wird auf die zu messende physikalische Grösse geschlossen. Kapazitive Sensoren werden entweder einzeln oder in Anordnungen von mehreren räumlich eng benachbarten Sensoren eingesetzt. Kapazitive Einzelsensoren werden beispielsweise zur Druck-, Beschleunigungs- und Positionsmessung verwendet. Kapazitive Anordnungen bzw. Mehrfachsensorsysteme finden beispielsweise beim kapazitiven Touch-Pad oder bei kapazitiven Fingerabdrucksensoren Anwendung. Figur 1 zeigt beispielhaft eine schematische Darstellung einer kapazitiven Sensoranordnung 1 mit mehreren kapazitiven (Mess-)Sensoren, die durch eine Sendeelektrode S und Empfangselektroden $E_1$, $E_2$, .... gebildet werden, wobei die eine Sendeelektrode S allen Sensoren gemeinsam ist. Die Empfangselektroden $E_1$, $E_2$, ... sind beabstandet von der Sendeelektrode S angeordnet. Es ist eine Signalquelle 2 zur Ansteuerung (bzw. zum Betrieb) der Sensoranordnung 1 vorgesehen.

Mit einer Sensoranordnung mit mehreren kapazitiven Sensoren können dreidimensionale dielektrische oder leitfähige Strukturen erfasst und abgetastet werden wie beispielsweise das Prägebild einer Münze (Beispiel für eine leitfähige Struktur) oder der Füllzustand einer Mikrotiterplatte, wie sie zum Beispiel in Pipettierautomaten verwendet wird (Beispiel für eine dielektrische Struktur).

Die kapazitive Sensoranordnung kann entweder mit Hilfe von getakteten elektrischen Signalen (so genannter getakteter Betrieb) oder mit Hilfe von sinusförmigen Signalen (so genannter linearer Betrieb) betrieben werden. Das von den Empfangselektroden abgegebene elektrische Signal, bei dem es sich üblicherweise um eine Spannung handelt, insbesondere dessen Amplitude, stellt ein Mass für die Kapazität des Sensors und somit für die zu messende physikalische Grösse dar. Beim linearen Betrieb treten in vorteilhafter Weise keine Oberwellen auf und es können somit im Wesentlichen keine unerwünschten Interferenzen entstehen. Ferner können schmalbandige Filter für die Signalverarbeitung verwendet werden. Dies führt auf einfache Weise zu einer Verbesserung des Signal-Rausch-Verhältnisses und der Empfindlichkeit des Sensors bzw. der Sensorenordnung. So können auch kleine Änderungen der Kapazität der Sensoranordnung festgestellt werden. Die vorliegende Erfindung bezieht sich insbesondere auf Anordnungen zum Messen einer physikalischen Grösse, die mit sinusförmigen Signalen betrieben werden.

Die Sensoranordnung kann sowohl einseitig geerdet als auch schwebend betrieben werden. Beim geerdeten Betrieb von eng benachbart angeordneten Sensoren tritt an der nicht geerdeten Elektrode üblicherweise eine Signalspannung auf, welche durch parasitäre kapazitive Kopplung auf die nicht geerdete Elektrode eines Nachbarsensors übersprechen kann. Dieses Übersprechen kann vorteilhafterweise durch einen schwebenden Betrieb der Sensoranordnung vermieden werden.

Figur 2a) zeigt eine schematische Darstellung einer geerdet betriebene Anordnung zum Messen einer physikalischen Grösse mit einem Messsensor 3, einem Referenzsensor 4 und einer Steuer-/Auswerteeinheit 5, die die Ausgangssignale des Messsensors 3 und des Referenzsensors 4 auswertet und ein der physikalischen Grösse entsprechendes Ausgangssignal $V_{out}$ ausgibt. Die dargestellte Anordnung wird mit einer Spannung $V_{pos}$ betrieben. Der Messsensor 3 und der Referenzsensor 4 weisen jeweils eine Kapazität mit einer Sendeelektrode 6 und einer Empfangselektrode 7 auf. Der Anschluss der jeweiligen Sendeelektrode 6 ist geerdet. Die Anschlüsse der Empfangselektroden 7 bilden die Ausgänge des Messsensors 3 und des Referenzsensors 4. Die Steuer-/Auswerteeinheit 5 bildet aus den Ausgangssignalen des Messsensors 3 und des Referenzsensor 4 eine Differenz, mittels derer die zu messende physikalische Grösse ermittelt werden kann.

Figur 2b) zeigt eine Anordnung zum Messen einer physikalischen Grösse, die schwebend betrieben wird. Es sind ein Messsensor 8 und ein Referenzsensor 9 vorgesehen, die jeweils eine Sendeelektrode 10, eine Empfangselektrode 11 und eine Empfangselektronik 12 aufweisen. Eine Empfangselektronik 12 ist jeweils mit einer Empfangselektrode 11 verbunden und verarbeitet das von dieser abgegebene Signal. Eine Steuer-/Auswerteeinheit 13 wertet die Ausgangssignale der Empfangselektroniken 12 aus, bildet insbesondere deren Differenz, und ermittelt aus diesen ein Ausgangssignal $V_{out}$, das der zu messenden physikalischen Grösse entspricht. Es ist eine Signalquelle 14 vorgesehen, die den Messsensor 8 und den Referenzsensor 9 mit Energie versorgt.

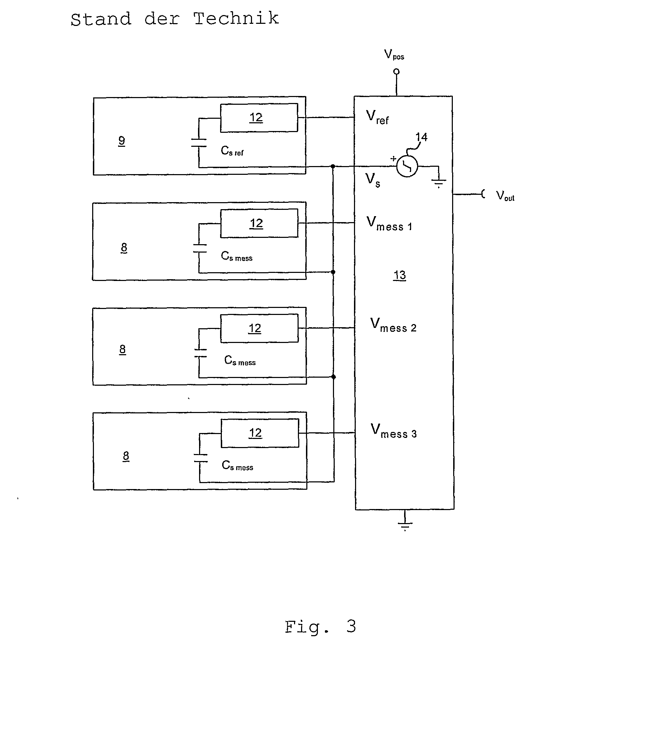

Es kann mehr als ein Messsensor 8 vorgesehen sein. Figur 3 zeigt beispielhaft eine Anordnung mit einem Referenzsensor 9 und drei Messsensoren 8, die schwebend betrieben wird.

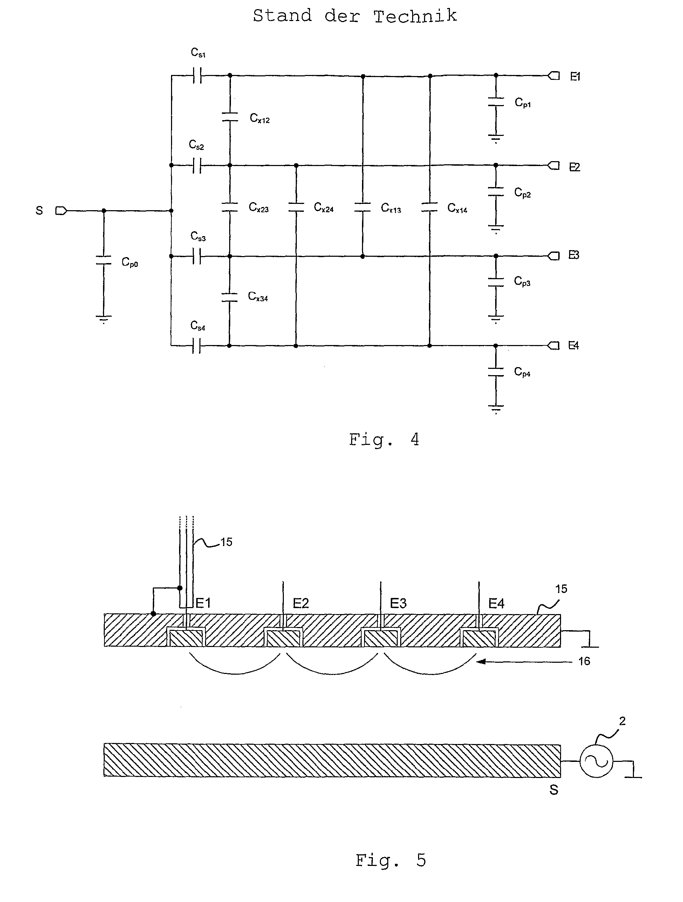

Bei Sensoranordnungen mit mehreren kapazitiven Sensoren treten häufig Übersprechkapazitäten auf, welche die Messergebnisse verfälschen können. Figur 4 zeigt schematisch eine schwebend betriebene Sensoranordnung mit mehreren kapazitiven Sensoren als konzentriertes Kapazitätsmodell. Beispielhaft ist eine Sensoranordnung mit vier (Mess-)Sensoren, d.h. mit einer Sendeelektrode S und vier Empfangselektroden E1, E2, E3, E4 dargestellt. Die Kapazitäten $C_{s1}$, $C_{s2}$, $C_{s3}$, $C_{s4}$ stellen die Sensorkapazitäten dar. Die weiteren dargestellten Kapazitäten im Kapazitätsmodell sind parasitär und wirken sich verfälschend auf die Messergebnisse aus. Es handelt sich hierbei um die vier Parallelkapazitäten $C_{p1}$, $C_{p2}$, $C_{p3}$, $C_{p4}$, die von den Empfangselektroden E1, E2, E3, E4 nach Masse führen sowie um sechs Übersprechkapazitäten $C_{x12}$, $C_{x23}$, $C_{x34}$, $C_{x13}$, $C_{x24}$, $C_{x14}$, welche die kapazitiven Kopplungen zwischen den Empfangselektroden E1, E2, E3, E4 darstellen. Die Parallelkapazität $C_{p0}$, die von der Sendeelektrode S nach Masse führt, ist im Wesentlichen wirkungslos, wenn die Sendeelektrode aus einer niederohmigen Spannungsquelle gespeist wird. Jede der Empfangselektroden E1, E2, E3, E4 ist mit einer nicht dargestellten Empfangselektronik verbunden, die das Ausgangssignal der jeweiligen Empfangselektrode E1, E2, E3, E4 verarbeitet und das verarbeitete Signal an eine nicht dargestellte Steuer-/Auswerteeinheit gibt.

Die bei der Kapazitätsmodellbildung zu berücksichtigende Anzahl von Parasitärkapazitäten hängt davon ab, wie genau das Kapazitätsmodell sein soll. Übersprechkapazitäten zwischen räumlich weit entfernt angeordneten Empfangselektroden sind üblicherweise klein im Verhältnis zu den übrigen Kapazitäten des Modells und können daher oftmals vernachlässigt werden. In der Regel ist es ausreichend, die Übersprechkapazitäten zur räumlich gesehen nächsten und übernächsten Empfangselektrode im Kapazitätsmodell zu berücksichtigen.

Die parasitären Kapazitäten $C_p$, $C_x$ haben die folgenden, sich negativ auf die Messergebnisse auswirkenden Wirkungen: Die Parallelkapazitäten Cp bilden zusammen mit der zugehörigen Sensorkapazität $C_s$ jeweils einen Spannungsteiler, der zu einer Verringerung der Amplitude des Ausgangssignals und somit zu einer Reduktion des Signal-Rausch-Verhältnisses und der Messgenauigkeit führt. Die Übersprechkapazitäten $C_x$ stellen Kopplungen zwischen benachbarten Empfangselektroden dar. Jedem von einer Empfangselektrode empfangenen Signal werden über die jeweiligen Übersprechkapazitäten Anteile der von den benachbarten Empfangselektroden empfangenen Signalen überlagert, was zu einer Verfälschung der Amplitude der Ausgangssignale und damit zu einem räumlichen Auflösungsverlust führt.

Ist die geometrische Anordnung der Sendeelektrode und der Empfangselektroden bekannt, so können mit Hilfe der Finite-Elemente-Methode (FEM) die Kapazitätswerte des in Figur 4 dargestellten Kapazitätsmodells berechnet werden. Sind das Kapazitätsmodell mit den Kapazitätswerten und der Aufbau der Empfangselektroniken bekannt, so können die von den Empfangselektroniken aufbereiteten Signale entweder analytisch oder mit Hilfe eines Schaltungssimulators berechnet werden. Auf diese Weise können die von verschiedenen Empfangselektroniken verarbeiteten Signale miteinander verglichen werden. Dies erlaubt einen Vergleich verschiedener Anordnungen zum Messen einer physikalischen Grösse, die jeweils eine Sensoranordnung mit mehreren kapazitiven Sensoren und diesen zugeordnete Empfangselektroniken umfassen. Bekannte Anordnungen zum Messen einer physikalischen Grösse liefern üblicherweise Signale, die von den Parallelkapazitäten Cp und/oder von den Übersprechkapazitäten $C_x$ beeinflusst sind.

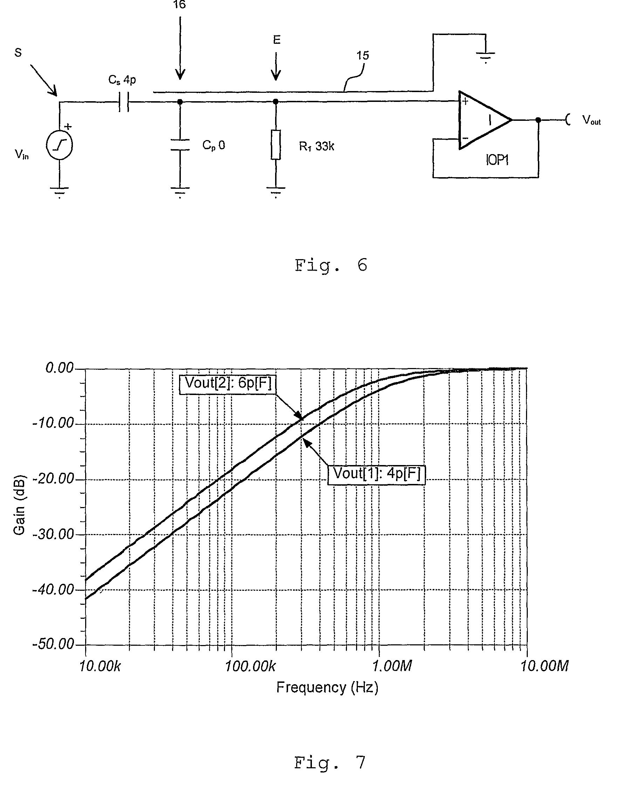

In den Figuren 5 und 6 ist eine Anordnung zum Messen einer physikalischen Grösse dargestellt, bei der gegenüber einer Sendeelektrode S beispielhaft vier Empfangselektroden E1, E2, E3, E4 räumlich nebeneinander angeordnet sind. Nicht näher bezeichnete Kabel, die mit einer Abschirmung 15 versehen sind, führen von den Empfangselektroden E1, E2, E3, E4 zu den in Figur 5 nicht näher dargestellten Empfangselektroniken. Die Abschirmung 15 ist geerdet und bildet die parasitäre Parallelkapazität zwischen Empfangselektrode und Masse. Figur 6 zeigt das der Anordnung in Fig. 5 entsprechende Blockschaltbild für eine Anordnung mit einer Empfangselektrode E. Die Sensorkapazität $C_s$ liegt zwischen der Sendeelektrode S und der Empfangselektrode E. Die der Empfangselektrode E nachgeschaltete Empfangselektronik wird durch einen Verstärker mit hochohmigem Eingang, beispielsweise einem Spannungsfolger mit einer Verstärkung 1, und einem diesem vorgeschalteten Widerstand $R_1$, der die Empfangselektrode E mit Masse verbindet, gebildet. Da in Richtung der Sendeelektrode S keine Abschirmung angebracht werden kann, bleibt die Wirkung der Abschirmung 15 unvollständig, sodass zwischen den Empfangselektroden Übersprechkapazitäten verbleiben. Die von den Empfangselektroden empfangenen Signale sind somit trotz Abschirmung 15 infolge des Übersprechens verfälscht.

Die Sensorkapazität $C_s$ bildet zusammen mit dem Widerstand $R_1$ einen Hochpassfilter. Unter Berücksichtigung der Parallelkapazität Cp zwischen Sendeelektrode S und Masse ergibt sich für den Hochpassfilter die Übertragungsfunktion als Laplace-Transformierte zu:

$$G(s) = \frac{C_s}{C_s + C_p} \cdot \frac{sT}{1 + sT}$$

mit der Zeitkonstanten $T = R_1(C_s + C_p)$. Für eine Betriebsfrequenz des (Mess-)Sensors von 300 Kilohertz, d.h. die Speisespannung bzw. Betriebsspannung des Sensors hat eine Frequenz von 300 Kilohertz, eine Sensorkapazität $C_s$ von 4 pF bzw. von 6 pF und eine Parallelkapazität Cp von 0 pF ergeben sich die in Figur 7 dargestellten Amplitudengänge. Der untere Amplitudengang in Fig. 7 entspricht einer Sensorkapazität von 4 pF und der obere Amplitudengang entspricht einer Sensorkapazität von 6 pF. Es sind zwei Amplitudengänge bei unterschiedlichen Sensorkapazitäten dargestellt, um deutlich zu machen, wie sich eine Sensorkapazitätsänderung auf das Ausgangssignal des in der Figur 6 dargestellten Blockschaltbilds auswirkt. Bei realen Änderungen, beispielsweise bei Pipettieranwendungen, können die Sensorkapazitätsänderungen im Bereich von wenigen Femtofarad liegen.

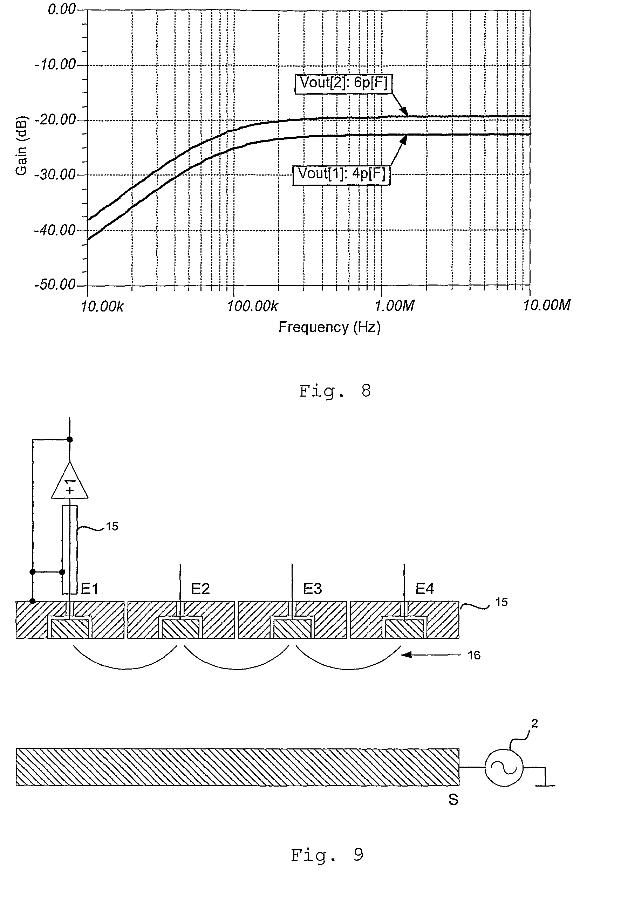

Aus Figur 7 ergibt sich, dass für eine Abhängigkeit der Amplitude des Ausgangssignals von der Sensorkapazität $C_s$ die Betriebsfrequenz des Sensors kleiner als die Grenzfrequenz der oben angegebenen Übertragungsfunktion, d.h. kleiner als die Grenzfrequenz des Hochpasses, gewählt werden muss. Für eine Parallelkapazität Cp von 0 pF ergibt sich eine Grenzfrequenz von $f = 1/(2\pi R_1 C_s)$. Bei einer Parallelkapazität Cp von grösser 0 F ergibt sich eine abgeschwächte Amplitude des Ausgangssignals, wie sich aus Figur 8 für eine Parallelkapazität Cp von 50 pF ergibt. Die Grenzfrequenz f beträgt für diesen Fall $f = 1/(2\pi R_1(C_s + C_p))$. Bei einem Betrieb mit einer Betriebsfrequenz unterhalb der Grenzfrequenz hängt die Amplitude des Ausgangssignals von der Betriebsfrequenz ab. Dies erfordert jedoch eine gute Stabilisierung der Betriebsfrequenz.

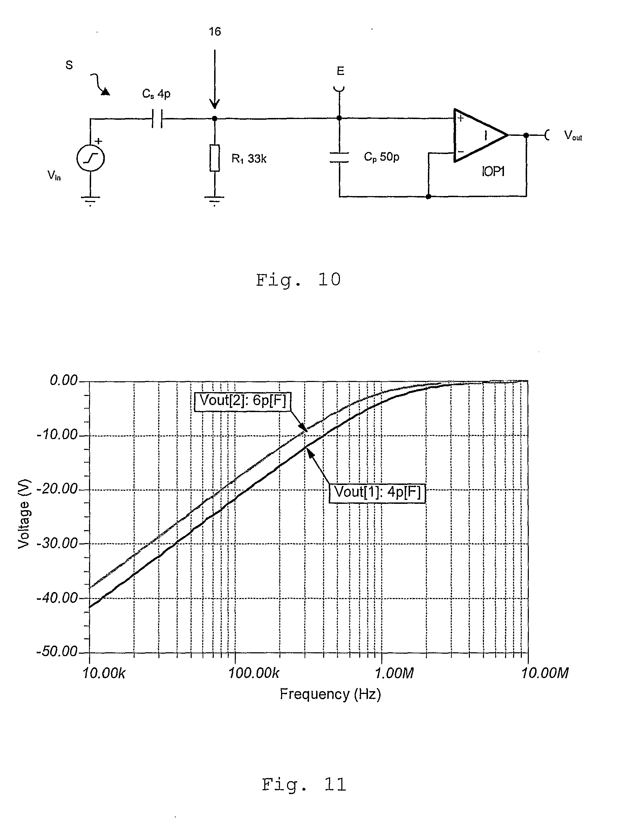

In den Figuren 9 und 10 ist eine Anordnung zum Messen einer physikalischen Grösse dargestellt, bei der die Abschirmung 15 auf demselben Potential liegt wie der Ausgang des von der Empfangselektronik umfassten Verstärkers IOP1 (so genanntes "Guarding"). Die Abschirmung 15 wird somit vom Ausgangssignal des Verstärkers IOP1 betrieben. Figur 11 zeigt die Amplitudengänge für eine Sensorkapazität $C_s$ von 4 pF bzw. 6 pF und eine Parallelkapazität Cp von 50 pF. Es ist ersichtlich, dass die Parallelkapazität Cp keinen Einfluss mehr auf die Amplitude des Ausgangssignals des in der Figur 10 dargestellten Blockschaltbilds hat. Die Übertragungsfunktion als Laplace-Transformierte ergibt sich zu:

$$G(s) = \frac{sT}{1 + sT}$$

mit der Zeitkonstanten $T = R_1 C_s$. Die das Ausgangssignal verfälschende Wirkung der Parallelkapazität Cp kann somit vermieden werden, jedoch verbleibt der Einfluss des Übersprechens 16 bzw. der Übersprechkapazitäten zwischen benachbarten Empfangselektroden auf das Ausgangssignal. Aus Figur 11 ergibt sich, dass die Betriebsfrequenz kleiner als die Grenzfrequenz der Übertragungsfunktion sein muss, damit sich eine Änderung der Sensorkapazität auf das Ausgangssignal auswirkt. Im Frequenzbereich unterhalb der Grenzfrequenz hängt jedoch die Amplitude des Ausgangssignals von der Betriebsfrequenz ab, was eine gute Stabilisierung der Betriebsfrequenz erfordert.

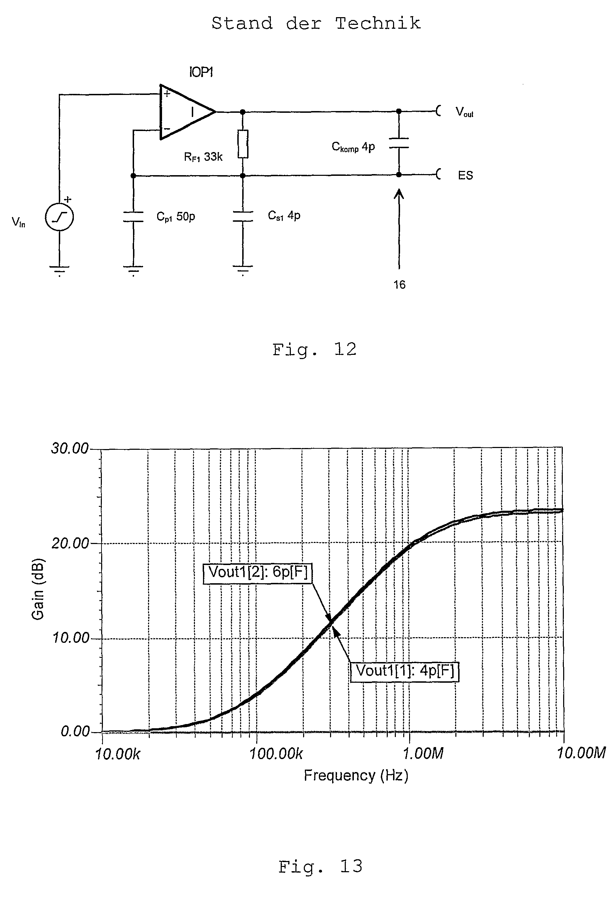

Figur 12 zeigt das Blockschaltbild einer weiteren Anordnung zum Messen einer physikalischen Grösse, bei der der kapazitive Messsensor geerdet betrieben wird, d.h. eine Elektrode des Messsensors liegt an Masse an, während die andere gleichzeitig als Sende- und Empfangselektrode ES betrieben wird. Die Elektrode wird spannungsgesteuert betrieben. Die der Elektrode zugeordnete Empfangselektronik übernimmt dadurch gleichzeitig die Funktion einer Sendeelektronik. Das Messsignal des Messsensors liegt an dem nicht invertierenden Eingang eines Operationsverstärkers IOP1 der Empfangselektronik an. Die Sensorkapazität $C_{s1}$ und die Parallelkapazität $C_{p1}$ des Sensors liegen zwischen dem invertierenden Eingang des Operationsverstärkers IOP1 und Masse in Parallelschaltung. Zwischen dem Ausgang des Operationsverstärkers IOP1 und dessen invertierendem Eingang liegen in Parallelschaltung ein Widerstand $R_{F1}$ und eine Kompensationskapazität $C_{komp}$ der Empfangselektronik. Über die Wahl der Kompensationskapazität $C_{komp}$ können eine Kompensation des Frequenz- bzw. Phasengangs erzielt und somit Schwingungen vermieden werden. Auf diese Weise kann wiederum ein kapazitives Übersprechen 16 von benachbart angeordneten Empfangs-/Sendeelektroden ES unterdrückt werden. Die Übertragungsfunktion des in Figur 12 dargestellten Blockschaltbilds als Laplace-Transformierte lautet:

$$G(s) = \frac{\dfrac{R_{F1}}{1 + sR_{F1}C_{komp}}}{\dfrac{1}{s(C_s + C_{p1})}} + 1 = \frac{sR_{F1}(C_{s1} + C_{p1})}{1 + sR_{F1}C_{komp}} + 1 = \frac{1 + sR_{F1}C_{komp} + sR_{F1}(C_{s1} + C_{p1})}{1 + sR_{F1}C_{komp}} = \frac{1 + sR_{F1}(C_{komp} + C_{s1} + C_{p1})}{1 + sR_{F1}C_{komp}}$$

$$G(s) = \frac{1 + sR_{F1}(C_{komp} + C_{s1} + C_{p1})}{1 + sR_{F1}C_{komp}} \cdot$$

Für sehr hohe Frequenzen vereinfacht sich die Übertragungsfunktion zu:

$$G(s)\big|_{s\to\infty} = \frac{V_{out}}{V_{in}} = \frac{C_{komp} + C_{s1} + C_{p1}}{C_{komp}} \cdot$$

Mit einer Sensorkapazität $C_{s1}$ und einer Kompensationskapazität $C_{komp}$ von jeweils 4 pF bzw. 6 pF, einer Parallelkapazität $C_{p1}$ von 50 pF und einem Widerstand $R_{F1}$ von 33 kOhm ergeben sich die in Figur 13 dargestellte Amplitudengänge. Für hohe Frequenzen ergibt sich für beide Sensorkapazitätswerte eine Verstärkung von 14.5 (entsprechend 23.2 Dezibel). Für hohe Parallelkapazitäten $C_{p1}$, insbesondere wenn $C_{p1} >> C_{s1}$, ergibt sich daher eine grosse Ausgangsamplitude, während die relative Änderung der Ausgangsamplitude bei Änderung der Sensorkapazität $C_{s1}$ abnimmt. Die Parallelkapazität $C_{p1}$ wirkt sich somit ungünstig auf die Ermittlung der Sensorkapazitätsänderung aus.
Der Einfluss des Übersprechens 16 kann hingegen mit der in Figur 12 dargestellten Anordnung reduziert werden, da die Sende-/Empfangselektrode ES infolge der Gegenkopplung niederohmig betrieben wird. Um eine ausreichende Unterdrückung des Übersprechens zu erzielen, wird von dem Operationsverstärker IOP1 in der Figur 12 ein grosses Verstärkungs-Bandbreite-Produkt verlangt (so genanntes gain-bandwidth-product). Bei einer Betriebsfrequenz von 10 Megahertz und einer geforderten Verstärkung von 100 ergibt sich ein Verstärkungs-Bandbreite-Produkt von 10 MHz x 100 x 14.5 = 14.5 GHz, was mit Standard-Operationsverstärkern nicht realisierbar ist. Der Faktor 14.5 entspricht einem Verstärkungswert von 23.2 Dezibel bei 10 Megahertz gemäss Figur 13. Bei einer reduzierten Betriebsfrequenz von 300 Kilohertz ergibt sich ein gut realisierbares Verstärkungs-Bandbreite-Produkt von 0.3 MHz x 100 x 4 = 120 MHz, wobei der Faktor 4 einer Verstärkung von 12 Dezibel bei 300 Kilohertz entspricht (vergleiche Figur 13). Bei einer Betriebsfrequenz von 300 Kilohertz, also unterhalb der Grenzfrequenz der in der Figur 12 dargestellten Anordnung, hängt jedoch das Ausgangssignal von der Betriebsfrequenz ab, was eine gute Stabilisierung der Betriebsfrequenz erforderlich macht.

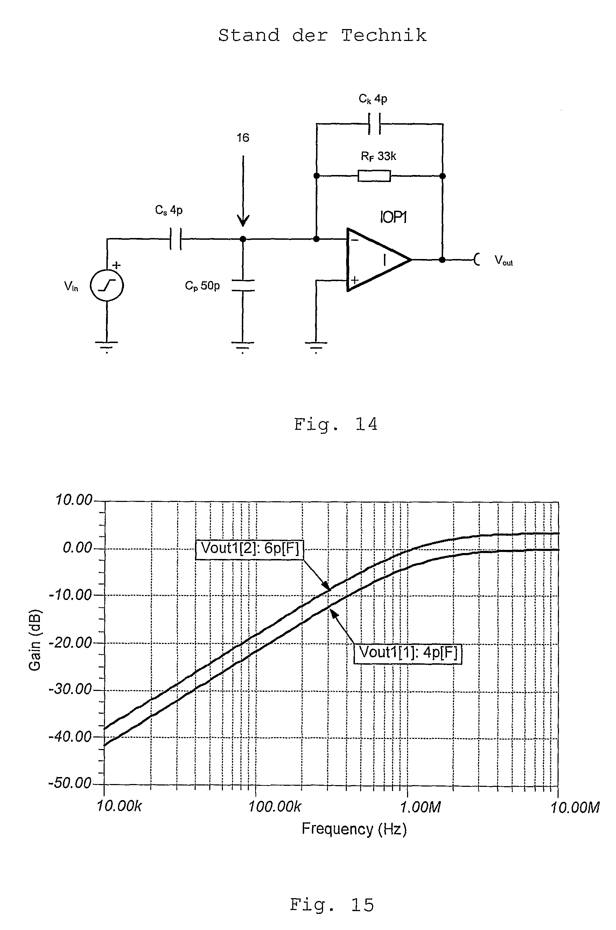

Figur 14 zeigt eine weitere bekannte Anordnung zum Messen einer physikalischen Grösse, bei der die Empfangselektroden mit dem invertierenden Eingang eines invertierenden Verstärkers bzw. Operationsverstärkers IOP1 einer Empfangselektronik verbunden sind. Der invertierende Verstärker IOP1 steuert bei Gegenkopplung seinen Ausgang so aus, dass die Differenzspannung an seinen Eingängen auf Null gehalten wird. Es kann daher angenommen werden, dass sich am invertierenden Eingang Massepotential einstellt. Der invertierende Eingang wird daher auch als virtuelle Masse bezeichnet. Die Sensorkapazität $C_s$ liegt dann zwischen der Signalspannung $V_{in}$ und der virtuellen Masse und eine Parallelschaltung aus einer Kompensationskapazität $C_k$ und einem Widerstand $R_F$, welche die Empfangselektronik aufweist, liegt zwischen dem Ausgang des invertierenden Verstärkers IOP1 und der virtuellen Masse. Die Parallelkapazität $C_p$ liegt zwischen der virtuellen Masse und der tatsächlichen Masse. Als Folge davon verschwindet der Strom, der durch die Parallelkapazität Cp fliesst, sodass die Parallelkapazität $C_p$ wirkungslos ist.
Die in Figur 14 dargestellte Anordnung wird beispielsweise als Eingangsverstärker für Photodioden, deren Parallelkapazität unwirksam gemacht werden soll, oder bei einem kapazitiven Sensor eingesetzt, wo sie ebenfalls der Beseitigung der Wirkung der Parallelkapazität dienen soll.
Die Übertragungsfunktion des in Figur 14 dargestellten Blockschaltbilds als Laplace-Transformierte lautet:

$$G(s) = -\frac{\dfrac{R_F}{1 + sR_FC_k}}{\dfrac{1}{sC_s}} = -\frac{sR_FC_s}{1 + sR_FC_k} = -\frac{C_s}{C_k} \cdot \frac{sR_FC_k}{1 + sR_FC_k}$$

Mit einer Sensorkapazität $C_s$ von 4 pF bzw. 6 pF, einer Kompensationskapazität $C_k$ von 4 pF, einem Widerstand $R_F$ von 33 kOhm und einer Parallelkapazität $C_p$ von 50 pF ergeben sich die in Figur 15 dargestellten Amplitudengänge. Die Amplitude des Ausgangssignals ist unabhängig von der Betriebsfrequenz, wenn die Betriebsfrequenz oberhalb der Grenzfrequenz der als Hochpass ausgebildeten, in Fig. 14 dargestellten Anordnung gewählt ist, d.h., die Betriebsfrequenz müsste grösser als $1/(2nR_FC_k) = 1.2$ MHz sein. Dies erfordert eine Anordnung mit einem grossen Verstärkungs-Bandbreite-Produkt.
Aus dem Dokument US 5,936,412 ist ein Kreislauf mit mehreren Elektroden bekannt, mit welchem die Gegenwart, Orientierung und Aktivität einer Person oder eines Objekts in einem definierten Raum bestimmt werden. Beispielsweise soll eine verbesserte Regulierung von Airbag-Einstellungen in Personenkraftwagen ermöglicht werden. Der Kreislauf umfasst eine Sendeelektrode und ein Paar Empfangselektroden, die voneinander beabstandet sind, sowie einen Operationsverstärker.

Das Dokument GB 2 286 247 beschreibt eine kapazitive Positionsbestimmung in einem definierten Raum mittels eines Sensors. Der Sensor umfasst eine Sendeelektrode und eine Empfangselektrode, die relativ zueinander in definierten Positionen angeordnet sind.

Darstellung der Erfindung

Es ist Aufgabe der vorliegenden Erfindung eine Anordnung zum Messen einer physikalischen Grösse mit mehreren Messsensoren zu schaffen, mit der der Einfluss von Übersprechen zwischen benachbarten Messsensoren verringert werden kann.

Diese Aufgabe wird durch eine Anordnung mit den Merkmalen des Anspruchs 1 gelöst.

Bei der erfindungsgemässen Anordnung ist jedem Messsensor ein invertierender Messsignalverstärker nachgeschaltet, wobei je ein Ausgang eines Messsensors mit einem negativen Eingang des dem Messsensor nachgeschalteten invertierenden Messsignalverstärkers verbunden ist. Bei den mehreren Messsensoren handelt es sich um kapazitive Sensoren, die durch eine Sendeelektrode und mehrere Empfangselektroden gebildet werden, wobei die Empfangselektroden beabstandet von der Sendeelektrode angeordnet sind. Alternativ können die Sende- und die Empfangselektroden auch vertauscht werden, sodass die Sensoren durch eine Empfangselektrode und mehrere Sendeelektroden gebildet werden.

Der invertierende Eingang eines invertierenden Messsignalverstärkers stellt eine virtuelle Masse dar. Somit sind die Ausgänge der Messsensoren, insbesondere der Empfangselektroden der Messsensoren, virtuell geerdet. Dies führt vorteilhafterweise dazu, dass ein kapazitives Übersprechen zwischen benachbarten Messsensorausgängen, insbesondere zwischen benachbarten Empfangselektroden, reduziert werden kann. Zusätzlich wird der Einfluss einer parasitären Parallelkapazität zwischen einem Messsensorausgang bzw. einer Empfangselektrode und Masse reduziert.

Jedem invertierenden Messsignalverstärker ist ein Integrator nachgeschaltet, an dessem invertierenden Eingang ein Ausgangssignal des jeweiligen invertierenden Messsignalverstärkers anliegt.

Auf diese Weise kann vorteilhafterweise erreicht werden, dass das Ausgangssignal der erfindungsgemässen Anordnung im Wesentlichen unabhängig von der Betriebsfrequenz ist. Dies hat eine reduzierte Alterungs- und Temperaturdrift zur Folge. Ferner wird für den oberen Betriebsfrequenzbereich ein Tiefpassverhalten der Anordnung erzielt, so dass hochfrequentes Rauschen unterdrückt werden kann.

Zudem ist jedem Messsensor ein Referenzsignalerzeuger zugeordnet, insbesondere ein Referenzsensor, dem ein invertierender Referenzsignalverstärker nachgeschaltet ist, wobei ein Ausgang des Referenzsignalerzeugers mit einem invertierenden Eingang des invertierenden Referenzsignalverstärkers verbunden ist. Das von dem Referenzsignalerzeuger erzeugte Referenzsignal hat vorzugsweise dieselbe Frequenz und dieselbe Phasenlage wie das vom Messsensor erzeugte Messsignal und seine Amplitude entspricht derjenigen des Messsignals, wenn sich der Messsensor im Ruhe- bzw. Referenzzustand befindet.

Durch Subtraktion des Ausgangssignals des invertierenden Referenzsignalverstärkers von dem Ausgangssignal des invertierenden Messsignalverstärkers kann ein Signal ermittelt werden, welches der Änderung der Sensorkapazität entspricht und von wesentlich geringerer Grössenordnung als das Messsignal bzw. das Referenzsignal ist. Wegen seiner geringen Amplitude kann das Differenzsignal auf eine Steuer-/Auswerteeinheit mit einer hohen Verstärkung gegeben werden, ohne dass Übersteuerungsgefahr besteht. Ferner ist das Differenzsignal empfindlicher gegenüber einer Änderung der Sensorkapazität als das Messsignal des Messsensors. Auch wird die Gefahr des Übersprechens zwischen den Leitungen, die die Empfangselektroniken 12 (vergleiche Fig. 2) mit der Steuer-/Aus-werteeinheit 13 (vergleiche Fig. 2) verbinden, reduziert, weil die Signalamplituden kleiner sind.

Kurze Beschreibung der Zeichnungen

Weitere vorteilhafte Ausgestaltungen der Erfindung ergeben sich aus den Unteransprüchen und den anhand der Zeichnungen nachfolgend dargestellten Ausführungsbeispielen. Es zeigen:

Figur 1 eine schematische Darstellung einer Sensoranordnung mit mehreren kapazitiven Sensoren,
Figur 2 ein Blockschaltbild einer Anordnung zum Messen einer physikalischen Grösse, die geerdet betrieben wird (a), und ein Blockschaltbild einer Anordnung zum Messen einer physikalischen Grösse, die schwebend betrieben wird (b),
Figur 3 ein Blockschaltbild einer Anordnung zum Messen einer physikalischen Grösse, die schwebend betrieben wird und die mehrere Messsensoren umfasst,

Figur 4 ein Kapazitätsmodell einer Sensoranordnung mit mehreren Sensoren,

Figur 5 eine schematische Darstellung einer Sensoranordnung mit mehreren Sensoren, bei denen die Empfangselektroden eine Abschirmung aufweisen,

Figur 6 ein Blockschaltbild betreffend die Sensoranordnung nach Figur 5,

Figur 7 ein Diagramm mit Amplitudengängen des in der Figur 6 dargestellten Blockschaltbilds,

Figur 8 ein weiteres Diagramm mit Amplitudengängen des Blockschaltbilds nach Figur 6,

Figur 9 eine schematische Darstellung einer Sensoranordnung mit mehreren kapazitiven Sensoren mit Guarding der Empfangselektroden,

Figur 10 ein Blockschaltbild der Anordnung nach Figur 9,

Figur 11 ein Diagramm mit Amplitudengängen des Blockschaltbilds nach Figur 10,

Figur 12 ein Blockschaltbild einer Sensoranordnung, bei der die Elektroden spannungsgesteuert sind,

Figur 13 ein Diagramm mit Amplitudengängen des Blockschaltbilds nach Figur 12,

Figur 14 ein Blockschaltbild einer Sensoranordnung mit einem invertierenden Verstärker,

Figur 15 ein Diagramm mit Amplitudengängen des Blockschaltbilds nach Figur 14,

Figur 16 eine schematische Darstellung einer Anordnung zum Messen einer physikalischen Grösse mit mehreren Messsensoren, wobei jedem Messsensor ein invertierender Messsignalverstärker zugeordnet ist,

Figur 17 eine schematische Darstellung einer Anordnung gemäss Figur 16 ohne Abschirmung der Empfangselektroden der Messsensoren,

Figur 18 ein Blockschaltbild der Anordnung nach Figur 17 mit parasitären Kapazitäten,

Figur 19 ein Schaltbild eines Messsensors mit nachgeschaltetem invertierenden Messsignalverstärker und nachgeschaltetem Integrator,

Figur 20 ein Diagramm mit Amplitudengängen des Schaltbilds nach Figur 19,

Figur 21 ein Blockschaltbild einer Anordnung zweier Messsensoren mit nachgeschalteten invertierenden Messsignalverstärkern und nachgeschaltetem Integrator,

Figur 22 ein Diagramm mit Amplitudengängen des Blockschaltbilds nach Figur 21,

Figur 23 ein Diagram mit Signalverläufen des Blockschaltbilds nach Figur 21,

Figur 24 ein Schaltbild einer Anordnung zweier Messsensoren mit nachgeschalteten Messsignalverstärkern, wobei jedem Messsignalverstärker ein Integrator nachgeschaltet ist, und

Figur 25 ein Schaltbild einer weiteren Anordnung zweier Messsensoren mit nachgeschalteten Messsignalverstärkern, wobei jedem Messsignalverstärker ein Integrator nachgeschaltet ist.

In den Figuren bezeichnen gleiche Bezugszeichen strukturell bzw. funktionell gleichwirkende Komponenten. Bei in den Blockschaltbildern angegebenen Werteangaben von elektronischen Bauteilen wurde der Einfachheit halber auf die Angabe der Einheit verzichtet.

Weg(e) zur Ausführung der Erfindung

Die Figuren 1-15 sind bereits in der Beschreibungseinleitung beschrieben. Es wird an dieser Stelle auf die Beschreibungseinleitung verwiesen.

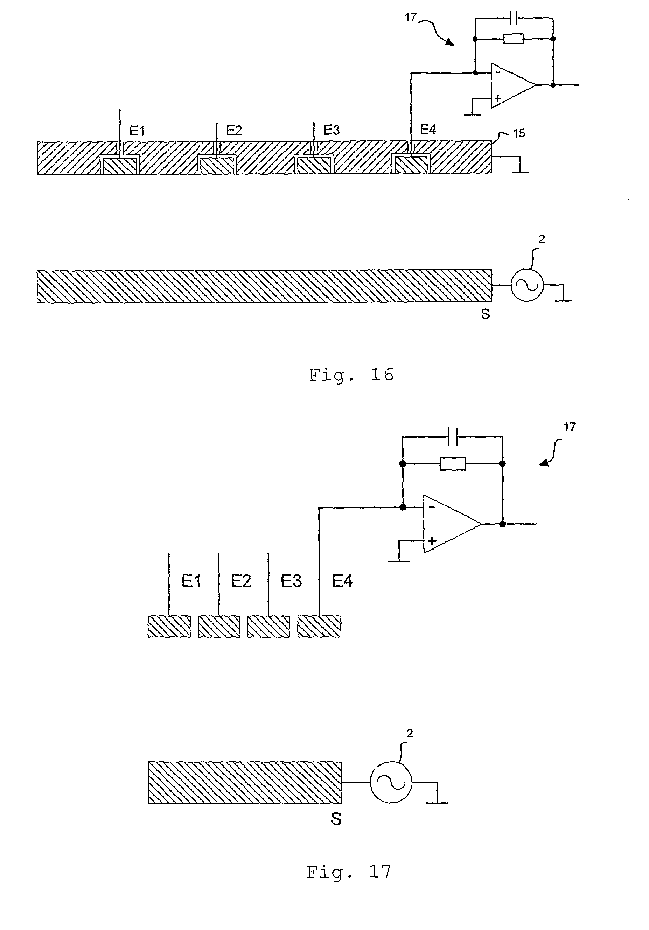

Figur 16 zeigt eine Anordnung zum Messen einer physikalischen Grösse mit mehreren Messsensoren, wobei jeder Messsensor als kapazitiver Sensor ausgestaltet ist und die Messsensoren durch eine Sendeelektrode S und mehrere Empfangselektroden E1, E2, E3, E4 gebildet werden. Die Empfangselektroden E1, E2, E3, E4, sind beabstandet von der Sendeelektrode S angeordnet. Es ist eine Energieversorgungsquelle 2 vorgesehen, die an die Sendeelektrode S angeschlossen ist. Die Empfangselektroden E1, E2, E3, E4, sind in einer räumlichen Ebene angeordnet, der so genannten Empfangsebene.

Insbesondere bei grösseren Abständen zwischen den Empfangselektroden E1, E2, E3, E4 in der Empfangsebene kann zwischen diesen eine Abschirmung 15 in Form einer Massenoberfläche vorgesehen sein, die geerdet ist. Auf diese Weise kann ein homogenes Wechselfeld zwischen der Sendeelektrode 2 und der Empfangsebene sichergestellt werden, was eine Voraussetzung für eine fehlerfreie Abtastung von beliebigen Objekten im Zwischenraum zwischen der Sendeelektrode S und der Empfangsebene ist, da das homogene Wechselfeld nur durch ein zu detektierendes Objekt beeinflusst werden soll.

An den Ausgang jedes Messsensors, d.h. an jede Empfangselektrode E1, E2, E3, E4 ist ein invertierender Messsignalverstärker 17 als Empfangselektronik angeschlossen. Der Einfachheit der Darstellung halber wurde in Figur 16 nur der mit der Empfangselektrode E4 verbundene invertierende Messsignalverstärker 17 dargestellt. An die Empfangselektroden E1, E2, E3 sind entsprechende invertierende Messsignalverstärker als Empfangselektroniken angeschlossen (nicht dargestellt). Die Empfangselektroden E1, E2, E3, E4 sind an die invertierenden Eingänge der jeweiligen invertierenden Messsignalverstärker 17 angeschlossen. Weil die invertierenden Eingänge der invertierenden Messsignalverstärker 17 virtuelle Massen darstellen, bleiben parasitäre Parallelkapazitäten, die zwischen den Empfangselektroden E1, E2, E3, E4 und der Abschirmung 15 entstehen, wirkungslos, da die Empfangselektroden E1, E2, E3, E4 über die virtuellen Massen virtuell geerdet sind.

Ein kapazitives Übersprechen zwischen den Empfangselektroden E1, E2, E3, E4 kann nicht erfolgen, da sämtliche Empfangselektroden E1, E2, E3, E4 virtuell geerdet sind. Aus diesem Grunde kann auf die Abschirmung 15 zwischen den Empfangselektroden E1, E2, E3, E4 verzichtet werden. Dies ist in Figur 17 dargestellt. In Figur 17 ist der Einfachheit der Darstellung halber nur der mit der Empfangselektrode E4 verbundene invertierende Messsignalverstärker dargestellt. Die Empfangselektroden E1, E2, E3 sind mit entsprechenden invertierenden Messsignalverstärkern 17 verbunden (nicht dargestellt). Durch den Wegfall der Abschirmung 15 können die Empfangselektroden E1, E2, E3, E4 in der Empfangsebene räumlich näher aneinander herangerückt werden, was deren Dichte pro Flächeneinheit und somit das räumliche Auflösungsvermögen der Anordnung mit mehreren kapazitiven Sensoren erhöht. Die Empfangsebene kann auf diese Weise besser ausgenutzt werden.

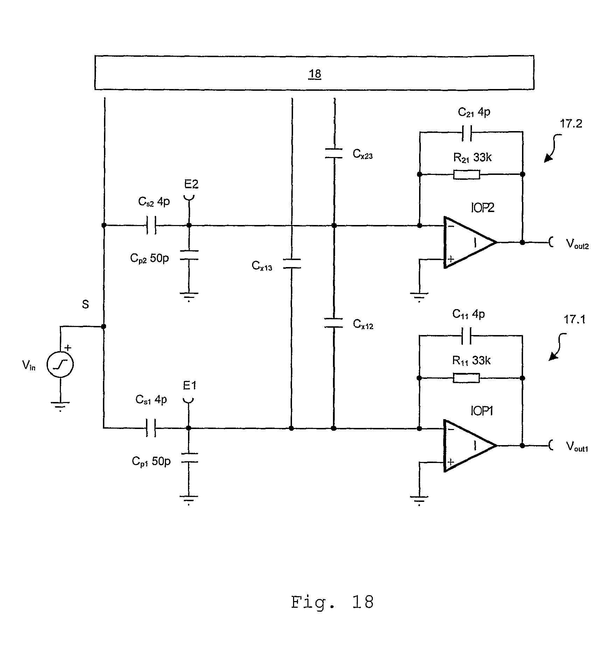

Figur 18 zeigt ein Blockschaltbild einer Anordnung zum Messen einer physikalischen Grösse gemäss Abbildung 17. Es ist eine gemeinsame Sendeelektrode S für sämtliche Messsensoren vorgesehen. Ferner sind die Empfangselektroden E1 und E2 zweier Messsensoren explizit dargestellt. Die Empfangselektrode E1 ist an einen invertierenden Eingang eines invertierenden Messsignalverstärkers 17.1 angeschlossen, der eine Empfangselektronik bildet. Die Elektrode E2 ist an einen invertierenden Eingang eines invertierenden Messsignalverstärkers 17.2 angeschlossen, der ebenfalls eine Empfangselektronik bildet. Block 18 stellt symbolisch weitere Empfangselektroden E3, E4, ... mit diesen zugeordneten invertierenden Messsignalverstärkern bzw. Empfangselektroniken dar. Die Gegenkopplung des invertierenden Messsignalverstärkers 17.1 wird durch eine Parallelschaltung der Kapazität $C_{11}$ und des Widerstandes $R_{11}$ gebildet. Die Gegenkopplung des invertierenden Messsignalverstärkers 17.2 wird durch eine Kapazität $C_{21}$ und einen Widerstand $R_{21}$ gebildet. Der erste Messsensor hat eine Sensorkapazität $C_{s1}$. Der zweite Sensor weist eine Sensorkapazität $C_{s2}$ auf. Das Blockschaltbild berücksichtigt die Übersprechkapazitäten $C_{x12}$, $C_{x13}$, $C_{x23}$, ... zwischen den Empfangselektroden E1, E2, .... Die Parallelkapazitäten $C_{p1}$ und $C_{p2}$ stellen die Kapazität der der jeweiligen Empfangselektrode E1, E2 zugeordneten, nicht näher bezeichneten Leitung zu den an die jeweilige Empfangselektrode E1, E2 angeschlossenen invertierenden Messsignalverstärker 17.1, 17.2 sowie dessen Eingangskapazität dar. Die Kapazitäten $C_{11}$, $C_{21}$ dienen der Frequenzkompensation und Schwingungsvermeidung.

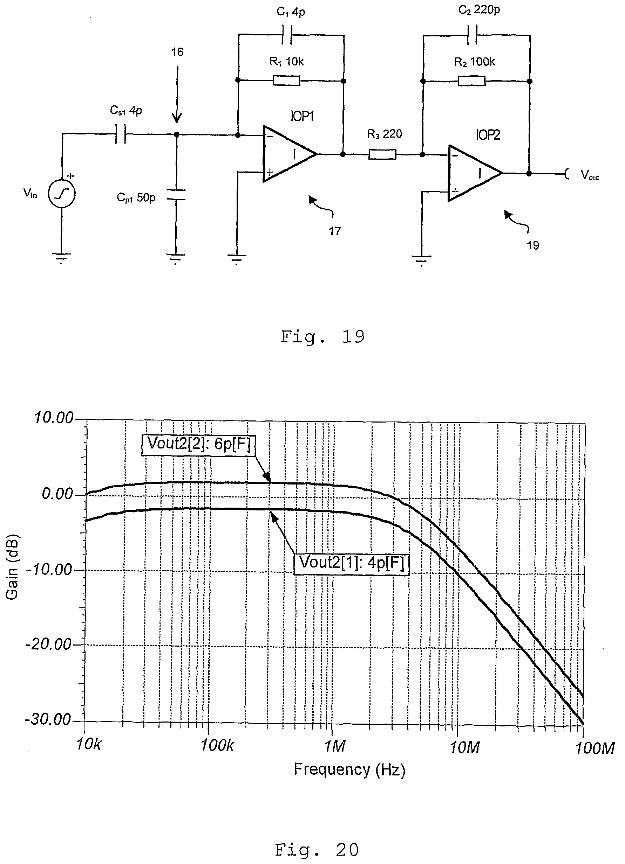

Figur 19 zeigt ein Schaltbild einer Anordnung zum Messen einer physikalischen Grösse mit einem Messsensor mit einer Sensorkapazität $C_{s1}$, dessen Empfangselektrode mit einem invertierenden Eingang eines invertierenden Messsignalverstärkers 17 verbunden ist. Die Gegenkopplung des Messsignalverstärkers 17 wird durch eine Parallelschaltung einer Kapazität $C_1$ und eines Widerstandes $R_1$ gebildet. Zwischen dem invertierenden Eingang des invertierenden Messsignalverstärkers 17 und Masse ist eine Parallelkapazität $C_{p1}$ berücksichtigt. Der Ausgang des invertierenden Messsignalverstärkers 17 ist über einen Widerstand $R_3$ an den invertierenden Eingang eines Integrators 19 angeschlossen. Die Gegenkopplung des Integrators bildet eine Parallelschaltung aus einer Kapazität $C_2$ und einem Widerstand $R_2$. Der invertierende Messsignalverstärker 17, der Integrator 19 und der Widerstand $R_3$ bilden eine Empfangselektronik. Die Übertragungsfunktion der in dem Blockschaltbild der Figur 19 dargestellten Anordnung als Laplace-Transformierte ergibt sich zu

$$G(s) = \frac{C_{s1}}{C_1} \cdot \frac{sR_1C_1}{1+sR_1C_1} \cdot \frac{R_2}{R_3} \cdot \frac{1}{1+sR_2C_2} \ .$$

Für die in Figur 19 angegebenen Werte der elektronischen Bauteile zeigt Figur 20 die Amplitudengänge bei einer Sensorkapazität $C_{s1}$ von 4 pF bzw. 6 pF. Das Ausgangssignal der in Figur 19 dargestellten Anordnung hängt im Frequenzbereich von 20 kHz bis 1 MHz vorteilhafterweise kaum von der Betriebsfrequenz ab. Bevorzugt wird eine Betriebsfrequenz von 300 kHz verwendet. Die Unabhängigkeit der in Figur 9 dargestellten Anordnung von der Betriebsfrequenz führt zu einer Erhöhung der Langzeitstabilität und der Temperaturunabhängigkeit, sodass leichte Änderungen der Betriebsfrequenz, wie sie beispielsweise bei Oszillatorschaltungen, die für die Generierung des Betriebssignals eingesetzt werden, infolge von Alter und Temperaturänderungen auftreten können, das Ausgangssignal der Anordnung nach Figur 19 im Wesentlichen nicht beeinflussen können.

Änderungen der Sensorkapazität $C_{s1}$ äussern sich bei einer Sensoranordnung mit mehreren kapazitiven Messsensoren als Änderung der Amplitude des Ausgangssignals. Bei empfindlichen Messsensoren können diese Änderungen sehr klein sein, beispielsweise 1/10'000 der Amplitude des (Betriebs-)Signals betragen. Das von der Signalquelle 14 (vergleiche Figur 2b) bzw. 2 (vergleiche Figur 17) an den Messsensor abgegebene Signal kann als Trägersignal betrachtet werden, dessen Amplitude durch die Änderung der Sensorkapazität moduliert wird. Da nur die Modulation bzw. Veränderung der Amplitude des Trägersignals bzw. Betriebssignals von Interesse ist und nicht die Amplitude des Trägersignals selbst, kann das Trägersignal bei der Bestimmung der Sensorkapazitätsänderung unterdrückt werden. Dies kann beispielsweise mittels einer Steuer-/Auswerteeinheit erfolgen, die einer Anordnung zum Messen einer physikalischen Grösse und den der Anordnung nachgeschalteten Empfangselektroniken nachgeschaltet ist. Bei Anordnungen mit mehreren Sensoren besteht ferner die Gefahr, dass bei der Übermittlung der Ausgangssignale an eine Steuer-/Auswerteeinheit unerwünschte Verkopplungen benachbarter Signalleitungen bzw. Übersprechen auf benachbarte Signalleitungen auftreten. Wenn beispielsweise nur 1/10'000 der Amplitude des Ausgangssignals eines Messsensors auf den einem benachbarten Messsensor zugeordneten Kanal bzw. dessen Signalleitung gelangt, so wird an diesem Kanal eine relativ grosse Messsensorkapazitätsänderung vorgetäuscht.

Die Verkopplung benachbarter Signalleitungen kann stark reduziert werden, wenn die Amplitude des Trägersignals bereits in den den Messsensoren zugeordneten Empfangsschaltungen ganz oder teilweise unterdrückt wird. Eine teilweise Unterdrückung kann ausreichend sein, wenn die den Empfangselektroniken nachgeschaltete Steuer-/Auswerteeinheit mit Trägerunterdrückung arbeitet.

Das Trägersignal bzw. Betriebssignal wird bevorzugt mittels einer Signalsubtraktion beseitigt. Zu diesem Zweck wird ein Träger- bzw. Betriebssignal benötigt, welches unmoduliert ist, d.h. welches von einer Sensorkapazitätsänderung unbeeinflusst ist. Das unmodulierte Trägersignal bildet dann das Referenzsignal $V_{ref}$. Frequenz und Phasenlage des Referenzsignals $V_{ref}$ stimmen bevorzugterweise mit der Frequenz- und der Phasenlage des von einem Messsensor gemessenen Signals $V_{mess}$ überein. Nach der Subtraktion ergibt sich ein Ausgangssignal von

$$V_{out} = V_{mess} - V_{ref},$$

wobei $V_{mess}$ das mit einem Messsensor gemessene Signal ist, $V_{ref}$ das Referenzsignal bildet, welches auch als unmoduliertes Trägersignal bezeichnet wird und welches im Wesentlichen dieselbe Frequenz und Phasenlage wie das Messsignal aufweist, wobei dessen Amplitude derjenigen des Messsignals entspricht, wenn sich der Messsensor in einem Ruhe- oder Referenzzustand befindet, und $V_{out}$ das Differenzsignal bzw. Ausgangssignal bildet, das der Amplitudenänderung des Messsignals bei einer Sensorkapazitätsänderung entspricht. Das Differenzsignal $V_{out}$ nimmt den Wert 0 an, wenn sich der Messsensor im Ruhe- oder Referenzzustand befindet, weil dann das Messsignal $V_{mess}$ gleich dem Referenzsignal $V_{ref}$ ist. Die durch die Sensorkapazitätsänderung hervorgerufene Änderung der Messsignalamplitude bleibt somit im Differenzsignal $V_{out}$ erhalten, während das Trägersignal nicht mehr in diesem enthalten bzw. unterdrückt ist.

Falls keine vollständige Unterdrückung des Trägersignals gewünscht wird, beispielsweise wenn die den Empfangselektroniken nachgeschaltete Steuer-/Auswerteeinheit besser arbeitet, falls das Differenzsignal $V_{out}$ einen gewissen Anteil des Trägersignals bzw. von dessen Trägeramplitude enthält, wird die Signalsubtraktion wie folgt modifiziert:

$$V_{out} = V_{mess} - aV_{ref},$$

wobei der Abschwächungsfaktor a kleiner 1 gewählt wird.

Die Bildung des Differenzsignals $V_{out}$ hat den Vorteil, dass einer der Anordnung zum Messen einer physikalischen Grösse nachgeschalteten Steuer-/Auswerteeinheit ein Signal mit einer relativ kleinen Amplitude zugeführt wird. Dies reduziert die Übersteuerungsgefahr in der Steuer-/Auswerteeinheit und erlaubt eine Vorverstärkung in der Steuer-/Auswerteeinheit bzw. in den Empfangselektroniken der Anordnung, die den Messsensoren nachgeschaltet sind. Ferner wird die Gefahr des Übersprechens zwischen den Kanälen von den Messsensoren zu der Steuer-/Auswerteeinheit und innerhalb der Steuer-/Auswerteeinheit verringert.

Das Referenzsignal $V_{ref}$ kann beispielsweise mit einem Referenzsignalerzeuger in Form eines Referenzoszillators erzeugt werden. Bevorzugt wird jedoch als Referenzsignalerzeuger ein Referenzsensor verwendet, der gleich aufgebaut ist wie ein Messsensor. Nur der Messsensor wird dann der zu messenden physikalischen Grösse ausgesetzt. Umgebungseinflüsse hingegen wie Temperatur und Feuchtigkeit, wirken sich auf beide Sensoren gleich aus. Bei der Subtraktion ihrer Ausgangsgrössen kann daher der Einfluss der Umgebungseinflüsse vermindert bzw. eliminiert werden.

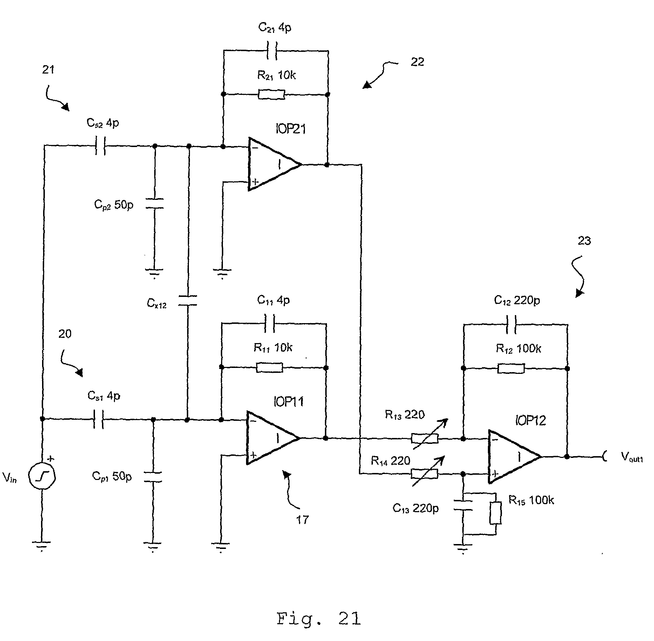

Figur 21 zeigt ein Blockschaltbild einer Anordnung zum Messen einer physikalischen Grösse, die als Ausgangssignal das Differenzsignal $V_{out1}$ ausgibt. Es sind ein Messsensor 20 mit einer Sensorkapazität $C_{s1}$ und einer Parallelkapazität $C_{p1}$ und ein Referenzsensor mit einer Sensorkapazität $C_{s2}$ und einer Parallelkapazität $C_{p2}$ vorgesehen. Der Referenzsensor 21 stellt den Referenzsignalerzeuger dar. Beispielhaft ist nur ein Messsensor 20 dargestellt. Erfindungsgemäß sind jedoch mehrere Messsensoren 20 mit zugehörigen Messsignalverstärkern 17 und Integratoren 23 vorgesehen, wobei jedem Messsensor 20 ein Referenzsensor 21 zugeordnet ist. Es können jedoch auch mehreren Messsensoren 20 ein einziger Referenzsensor 21 zugeordnet sein.

Zwischen dem Ausgang des Messsensors 20 und dem Ausgang des Referenzsensors 21 ist eine parasitäre Übersprechkapazität $C_{x12}$ berücksichtigt. Der Ausgang des Messsensors 20 ist mit einem invertierenden Eingang eines invertierenden Messsignalverstärkers 17 verbunden, dessen Gegenkopplung eine Parallelschaltung aus einer Kapazität $C_{11}$ und einem Widerstand $R_{11}$ aufweist. Der Ausgang des Referenzsensors 21 ist mit einem invertierenden Eingang eines invertierenden Referenzsignalverstärkers 22 verbunden, dessen Gegenkopplung eine Parallelschaltung aus einer Kapazität $C_{21}$ und einem Widerstand $R_{21}$ aufweist. Der invertierende Messsignalverstärker 17 und/oder der invertierende Referenzsignalverstärker 22 sind vorzugsweise als Hochpass ausgeführt.

Dem invertierenden Messsignalverstärkers 17 ist ein Integrator 23 nachgeschaltet, dessen invertierender Eingang über einen Widerstand $R_{13}$ mit dem Ausgang des invertierenden Messsignalverstärkers 17 verbunden ist und dessen nicht invertierender Eingang über einen Widerstand $R_{14}$ mit dem Ausgang des invertierenden Referenzsignalverstärkers 22 verbunden ist. Die Widerstände $R_{13}$ und $R_{14}$ sind vorzugsweise einstellbar bzw. können getrimmt werden. Der nicht invertierende Eingang des Integrators 23 ist über eine Kapazität $C_{13}$ und einen Widerstand $R_{15}$ mit Masse verbunden. Die Gegenkopplung des Integrators 23 wird durch eine Parallelschaltung einer Kapazität $C_{12}$ und eines Widerstandes $R_{12}$ gebildet.

Das Ausgangssignal $V_{out1}$ des Integrators 23 bildet somit die integrierte Differenz aus dem Ausgangssignal des invertierenden Messsignalverstärkers 17 und dem Ausgangssignal des invertierenden Referenzsignalverstärkers 22, wodurch eine Unterdrückung des Trägersignals bzw. Referenzsignals im Ausgangssignal $V_{out1}$ erzielt werden kann. Durch Trimmen des Widerstandes $R_{13}$ kann die Unterdrückung des Trägersignals optimiert werden. Eine weitere Optimierung der Unterdrückung des Trägersignals kann durch Trimmen sowohl des Widerstandes $R_{13}$ als auch des Widerstandes $R_{14}$ erzielt werden.

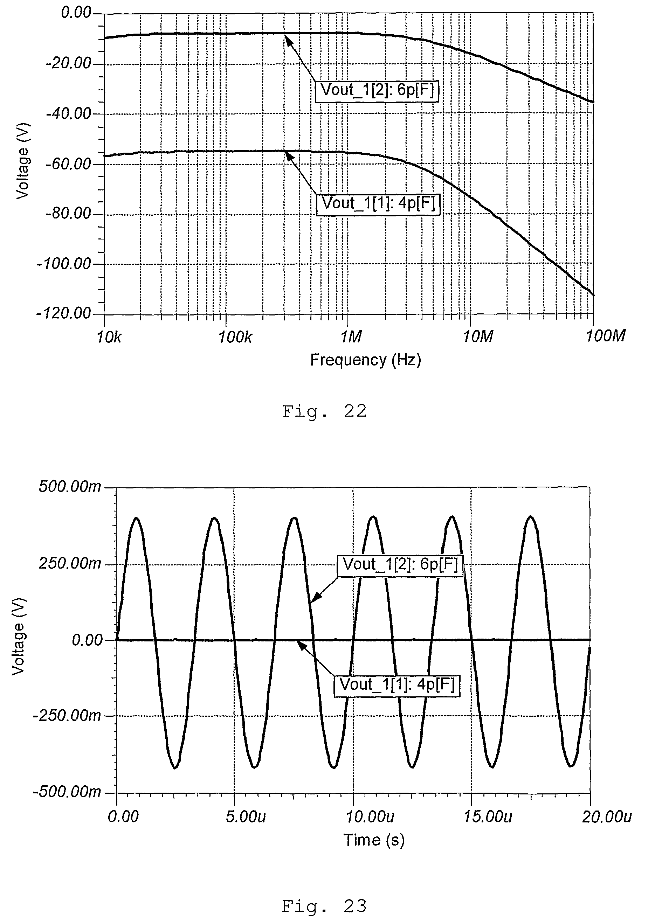

Figur 22 zeigt ein Diagramm mit Amplitudengängen des in Figur 21 dargestellten Schaltbildes für eine Sensorkapazität $C_{s1}$ von 4 pF bzw. 6 pF. Für die Berechnung der Amplitudengänge in Figur 22 und der Signalverläufe in Figur 23 wurden den in Figur 21 dargestellten Bauteilen ferner die in Figur 21 angegebenen Werte zugewiesen. Bei den Amplitudengängen in Figur 22 ist eine deutliche Abhängigkeit der Amplitude des Ausgangssignals $V_{out1}$ von der Sensorkapazität erkennbar. Die Subtraktion eines Referenzsignals von dem Messsignal wirkt sich somit positiv auf die Empfindlichkeit des Ausgangssignals $V_{out1}$ gegenüber Änderungen der Sensorkapazität $C_{s1}$ aus.

Das Diagramm in Figur 23 zeigt die Kurvenverläufe des Ausgangssignals $V_{out1}$ über der Zeit für eine Sensorkapazität $C_{s1}$ von 4 pF bzw. 6 pF. Die Sensorkapazität $C_{s1}$ von 4 pF stellt den Ruhe- oder Referenzzustand des Messsensors 20 dar, in welchem die Sensorkapazität $C_{s1}$ des Messsensors 20 der Sensorkapazität $C_{s2}$ des Referenzsensors 21 entspricht. Dementsprechend entspricht für eine Sensorkapazität $C_{s1}$ von 4 pF das Ausgangssignal des Messsensors 20 im Wesentlichen dem Ausgangssignal des Referenzsensors 21 und das Differenzsignal $V_{out1}$ ist im Wesentlichen 0. Bei Erhöhung der Sensorkapazität $C_{s1}$ des Messsensors 20 auf 6 pF wird die Amplitude der Ausgangs- bzw. Differenzspannung $V_{out1}$ stark erhöht.

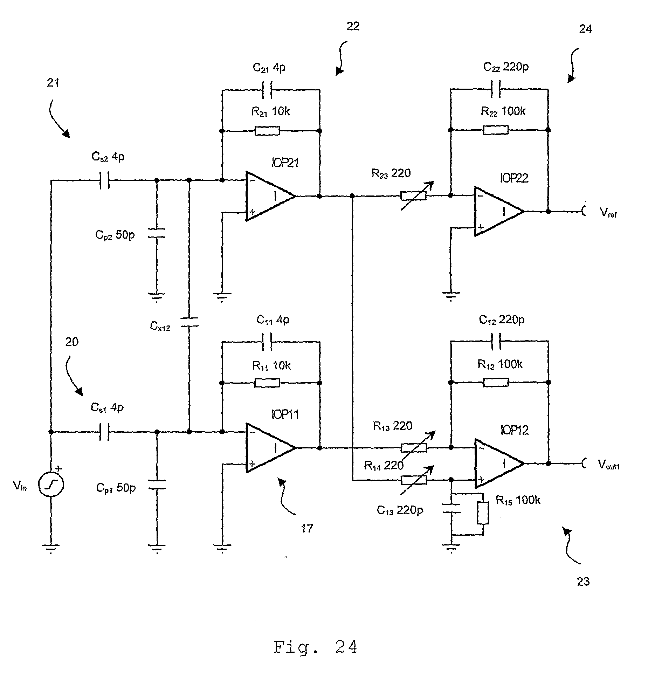

Einige Steuer-/Auswerteeinheiten zur Auswertung des Differenzsignals $V_{out1}$, welche der in der Figur 21 dargestellten Anordnung nachgeschaltet werden können, benötigen für die Auswertung ein Referenzsignal, dessen Frequenz und Phasenlage mit dem Messsignal übereinstimmt. Dies ist beispielsweise für so genannte Lock-in-Verstärker und Synchrongleichrichter der Fall. Das Referenzsignal kann für einen solchen Fall mittels einer Anordnung, wie sie in Figur 24 als Schaltbild dargestellt ist, aus dem Ausgangssignal des Referenzsensors 21 abgeleitet werden.

Die in Figur 24 dargestellte Anordnung entspricht der in Figur 21 dargestellten Anordnung, wobei zusätzlich dem invertierenden Referenzsignalverstärker 22 ein Integrator 24 nachgeschaltet ist, dessen invertierender Eingang über einen Widerstand $R_{23}$ mit dem Ausgang des invertierenden Referenzsignalverstärkers 22 verbunden ist. Der nicht invertierende Eingang des Integrators 24 liegt an Masse an. Die Gegenkopplung des dem invertierenden Referenzsignalverstärker 22 nachgeschalteten Integrators 24 wird durch eine Parallelschaltung aus einer Kapazität $C_{22}$ und einem Widerstand $R_{22}$ gebildet, deren Werte vorzugsweise den Werten der Kapazität $C_{12}$ und des Widerstandes $R_{12}$ des Integrators 23 entsprechen, der dem invertierenden Messsignalverstärker 17 nachgeschaltet ist. Am Ausgang des dem invertierenden Referenzsignalverstärker 22 nachgeschalteten Integrators 24 liegt das Referenzsignal $V_{ref}$ an, welches phasengleich zu dem Ausgangs- bzw. Differenzsignal $V_{out1}$ ist, das am Ausgang des Integrators 23, der dem invertierenden Messsignalverstärker 17 nachgeschaltet ist, anliegt, da sowohl in dem Referenzsignalpfad bzw. in dem Pfad des Referenzsensors 21 als auch in dem Messsignalpfad bzw. in dem Pfad des Messsensors 20 des Schaltbilds von Figur 24 ein Signalverstärker 17, 22 und Integrator 23, 24 vorgesehen sind.

Über ein Trimmen der Widerstände $R_{13}$, $R_{14}$ kann wiederum ein Unterdrücken des Trägersignals optimiert werden. Der Widerstand $R_{23}$ zwischen dem Ausgang des invertierenden Referenzsignalverstärkers 22 und dem invertierenden Eingang des Integrators 24 wird vorzugsweise entsprechend der Widerstände $R_{13}$, $R_{14}$ getrimmt, um ein gleiches Übertragungsverhalten sicherzustellen.

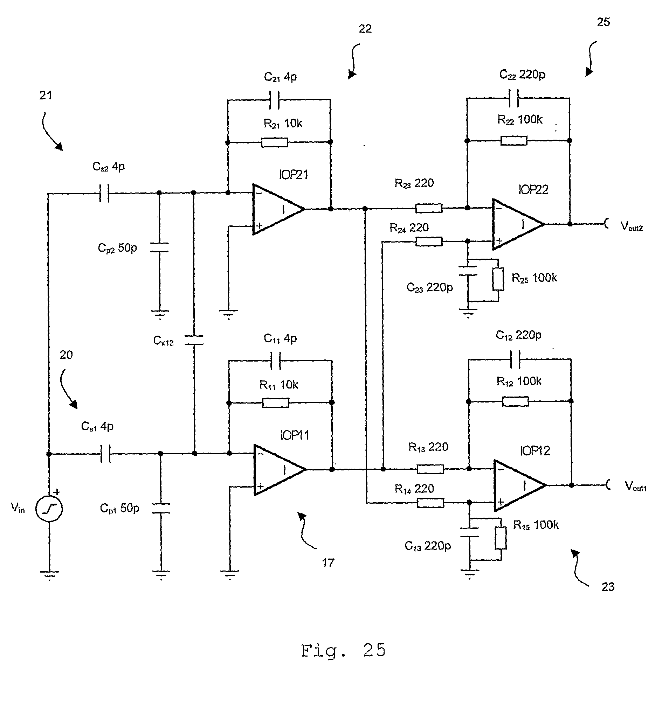

Ist eine Steuer-/Auswerteeinheit, welche einer Anordnung zum Messen einer physikalischen Grösse nachgeschaltet ist, derart ausgelegt, dass sie symmetrisch arbeitet, so werden vorzugsweise der Messpfad und der Referenzpfad der Anordnung gemäss Figur 25 symmetrisch ausgelegt, indem sowohl im Messpfad als auch im Referenzpfad durch den jeweiligen Integrator 23, 25 das Signal des anderen Pfades subtrahiert wird. Das in Figur 25 dargestellte Schaltbild entspricht dem in Figur 24 dargestellten Schaltbild, wobei für die Referenzbildung im Referenzpfad der nicht invertierende Eingang des dem invertierenden Referenzsignalverstärker 22 nachgeschalteten Integrators 25 über einen Widerstand $R_{24}$ mit dem Ausgang des invertierenden Messsignalverstärkers 17 verbunden ist. Der nicht invertierende Eingang des Integrators 25 ist ferner über eine Kapazität $C_{23}$ und einen Widerstand $R_{25}$ mit Masse verbunden.

Der Widerstand $R_{24}$ und die Kapazität $C_{23}$ entsprechen wertemässig vorzugsweise dem Widerstand $R_{14}$ und der Kapazität $C_{13}$ des Integrators 23, welcher dem invertierenden Messsignalverstärker 17 nachgeschaltet ist. Somit stellt das Ausgangssignal $V_{out2}$ des im Referenzpfad enthaltenen Integrators 25 die integrierte Differenz aus dem Ausgangssignal des invertierenden Referenzsignalverstärkers 22 und dem Ausgangssignal des invertierenden Messsignalverstärkers 17 dar.

Während in der vorliegenden Anmeldung bevorzugte Ausführungen bzw. Ausführungen der Erfindung beschrieben sind, ist klar darauf hinzuweisen, dass die Erfindung nicht auf diese Weise beschränkt ist und auch in anderer Weise innerhalb des Umfangs der folgenden Ansprüche ausgeführt werden kann.

## Patentansprüche

1. Anordnung zum Messen einer physikalischen Grösse, insbesondere zum Messen eines Füllzustandes, mit mehreren Messsensoren (20),

   wobei es sich bei den Messsensoren (20) um kapazitive Messsensoren (20) handelt und jedem Messsensor (20) ein invertierender Messsignalverstärker (17; 17.1, 17.2) nachgeschaltet ist, wobei je ein Ausgang eines Messsensors (20) mit einem invertierenden Eingang des dem Messsensor (20) nachgeschalteten invertierenden Messsignalverstärkers (17; 17.1, 17.2) verbunden ist, und

   wobei die mehreren Messsensoren (20) durch eine Sendeelektrode (S) und mehrere Empfangselektroden (E; E1, E2, E3, E4) gebildet werden, wobei die Empfangselektroden (E; E1, E2, E3, E4) beabstandet von der Sendeelektrode (S) angeordnet sind,

   **dadurch gekennzeichnet, dass** jedem Messsensor (20) ein Referenzsignalerzeuger (21) zugeordnet ist, dem ein invertierender Referenzsignalverstärker (22) nachgeschaltet ist, wobei ein Ausgang des Referenzsignalerzeugers (21) mit einem invertierenden Eingang des invertierenden Referenzsignalverstärkers (22) verbunden ist,

   und dass jedem invertierenden Messsignalverstärker (17; 17.1, 17.2) ein Integrator (23) nachgeschaltet ist, an dessen invertierendem Eingang ein Ausgangssignal des invertierenden Messsignalverstärkers (17; 17.1, 17.2) und an dessen nichtinvertierendem Eingang ein Ausgangssignal des invertierenden Referenzsignalverstärkers (22) anliegt, der dem Referenzsignalerzeuger (21) nachgeschaltet ist, der dem Messsensor (20) zugeordnet ist, dem der invertierende Messsignalverstärker (17; 17.1, 17.2) nachgeschaltet ist.

2. Anordnung nach Anspruch 1, **dadurch gekennzeichnet, dass** die Empfangselektroden (E; E1, E2, E3, E4) in einer räumlichen Ebene angeordnet sind und in der räumlichen Ebene zwischen den Empfangselektroden (E; E1, E2, E3, E4) keine Abschirmung vorgesehen ist.

3. Anordnung nach Anspruch 1, **dadurch gekennzeichnet, dass** dem invertierenden Referenzsignalverstärker (22) ein Integrator (25) nachgeschaltet ist, an dessen invertierendem Eingang ein Ausgangssignal des invertierenden Referenzsignalverstärkers (22) anliegt.

4. Anordnung nach Anspruch 3, **dadurch gekennzeichnet, dass** an dem nichtinvertierenden Eingang des dem invertierenden Referenzsignalverstärker (22) nachgeschalteten Integrators (25) ein Ausgangssignal des invertierenden Messsignalverstärkers (17; 17.1, 17.2) anliegt, der dem Messsensor (20) nachgeschaltet ist, dem der Referenzsignalerzeuger (21) zugeordnet ist, dem der invertierende Referenzsignalverstärker (22) nachgeschaltet ist.

5. Anordnung nach einem der vorhergehenden Ansprüche, **dadurch gekennzeichnet, dass** die invertierenden Messsignalverstärker (17; 17.1, 17.2) und/oder der invertierende Referenzsignalverstärker (22) jeweils als Hochpass ausgeführt sind.

6. Anordnung nach einem der vorhergehenden Ansprüche, **dadurch gekennzeichnet, dass** sie zum Messen eines Füllzustandes ausgelegt ist.

## Claims

1. An arrangement for measuring a physical quantity, especially for measuring a filling state, comprising several measuring sensors (20), wherein the measuring sensors (20) concern capacitive measuring sensors (20) and each measuring sensor (20) is connected downstream to an inverting measuring signal amplifier (17; 17.1, 17.2), wherein one output each of a measuring sensor (20) is connected to an inverting input of the inverting measuring signal amplifier (17; 17.1, 17.2) which is connected downstream of the measuring sensor (20), and wherein the several measuring sensors (20) are formed by a transmitting electrode (S) and several receiving electrodes (E; E1, E2, E3, E4), wherein the receiving electrodes (E; E1, E2, E3, E4) are arranged to be spaced from the transmitting electrode (S),

**characterized in that** a reference signal generator (21) is associated with each measuring sensor (20), to which an inverting reference signal amplifier (22) is connected downstream, wherein one output of the reference signal generator (21) is connected to an inverting input of the inverting reference signal amplifier (22), and that to each inverting measuring signal amplifier (17; 17.1, 17.2) an integrator (23) is connected downstream, with an output signal of the inverting measuring signal amplifier (17; 17.1, 17.2) being applied to the inverting input of said integrator and an output signal of the inverting reference signal amplifier (22) being applied to its non-inverting input, which reference signal amplifier (22) is connected downstream of the reference signal generator (21) which is associated with the measuring sensor (20), to which the inverting measuring signal amplifier (17; 17.1, 17.2) is connected downstream.

2.  An arrangement according to claim 1, **characterized in that** the receiving electrodes (E; E1, E2, E3, E4) are arranged in a spatial plane and no shielding is provided in the spatial plane between the receiving electrodes (E; E1, E2, E3, E4).

3.  An arrangement according to claim 1, **characterized in that** an integrator (25) is connected downstream of the inverting reference signal amplifier (22), to the inverting input of which an output signal of the inverting reference signal amplifier (22) is applied.

4.  An arrangement according to claim 3, **characterized in that** an output signal of the inverting measuring signal amplifier (17; 17.1, 17.2) is applied to the non-inverting input of the integrator (25) connected downstream of the inverting reference signal amplifier (22), which inverting measuring signal amplifier is connected downstream of the measuring sensor (20) with which the reference signal generator (21) is associated, to which the inverting reference signal amplifier (22) is connected downstream.

5.  An arrangement according to one of the preceding claims, **characterized in that** the inverting measuring signal amplifiers (17; 17.1, 17.2) and/or the inverting reference signal amplifier (22) are each formed as a high-pass filter.

6.  An arrangement according to one of the preceding claims, **characterized in that** it is formed to measure a filling state.


**Revendications**

1.  Système pour mesurer une grandeur physique, en particulier pour mesurer un niveau de remplissage, comprenant plusieurs capteurs de mesure (20), les capteurs de mesure (20) étant des capteurs de mesure capacitifs (20), un amplificateur de signaux de mesure inverseur (17 ; 17.1, 17.2) étant monté en aval de chaque capteur de mesure (20), une sortie d'un capteur de mesure (20) étant raccordée à une entrée inverseuse de l'amplificateur de signaux de mesure inverseur (17 ; 17.1, 17.2) monté en aval du capteur de mesure (20), la pluralité de capteurs de mesure (20) étant formée par une électrode émettrice (S) et plusieurs électrodes réceptrices (E ; E1, E2, E3, E4), les électrodes réceptrices (E ; E1, E2, E3, E4) étant agencées à distance de l'électrode émettrice (S), **caractérisé en ce qu'**il est associé à chaque capteur de mesure (20) un générateur de signaux de référence (21), en aval duquel est monté un amplificateur de signaux de référence inverseur (22), une sortie du générateur de signaux de référence (21) étant raccordée à une entrée inverseuse de l'amplificateur de signaux de référence inverseur (22), et **en ce qu'**il est monté en aval de chaque amplificateur de signaux de mesure inverseur (17 ; 17.1, 17.2) un intégrateur (23), à l'entrée inverseuse duquel est appliqué un signal de sortie de l'amplificateur de signaux de mesure inverseur (17 ; 17.1, 17.2) et à l'entrée non inverseuse duquel est appliqué un signal de sortie de l'amplificateur de signaux de référence inverseur (23), lequel est monté en aval du générateur de signaux de référence (21), qui est associé au capteur de mesure (20), en aval duquel est monté l'amplificateur de signaux de mesure inverseur (17 ; 17.1, 17.2).

2.  Système selon la revendication 1, **caractérisé en ce que** les électrodes réceptrices (E ; E1, E2, E3, E4) sont agencées dans un plan spatial et **en ce qu'**il n'est pas prévu de blindage dans le plan spatial entre les électrodes réceptrices (E ; E1, E2, E3, E4).

3.  Système selon la revendication 1, **caractérisé en ce qu'**il est monté en aval de l'amplificateur de signaux de référence inverseur (22) un intégrateur (25), à l'entrée inverseuse duquel il est appliqué un signal de sortie de l'amplificateur de signaux de référence inverseur (22).

**4.** Système selon la revendication 3, **caractérisé en ce qu'**il est appliqué à l'entrée non inverseuse de l'intégrateur (25) monté en aval de l'amplificateur de signaux de référence inverseur (22) un signal de sortie de l'amplificateur de signaux de mesure inverseur (17 ; 17.1, 17.2), lequel est monté en aval du capteur de mesure (20), auquel est associé le générateur de signaux de référence (21), en aval duquel est monté l'amplificateur de signaux de référence inverseur (22).

**5.** Système selon l'une des revendications précédentes, **caractérisé en ce que** les amplificateurs de signaux de mesure inverseurs (17 ; 17.1, 17.2) et/ou l'amplificateur de signaux de référence inverseur (22) sont réalisés sous la forme d'un filtre passe-haut.

**6.** Système selon l'une des revendications précédentes, **caractérisé en ce qu'**il est conçu pour mesurer un niveau de remplissage.

E1, E2, ...

1

S

2

Fig. 1

Stand der Technik

$V_{pos}$

7

4    $C_s$

6

5    ( $V_{out}$

7

3    $C_s$

6

$V_{pos}$

9    11    12    $V_{ref}$

10    $C_{s\,ref}$

13    ( $V_{out}$

8    11    12    $V_{mess}$

10    $C_{s\,mess}$    14

$V_s$

a)    b)

Fig. 2

Stand der Technik

Fig. 3

Stand der Technik

Fig. 4

Fig. 5

Fig. 6

Fig. 7

Fig. 8

Fig. 9

Fig. 10

Fig. 11

Stand der Technik

Fig. 12

Fig. 13

Stand der Technik

Fig. 14

Fig. 15

Fig. 16

Fig. 17

Fig. 18

Fig. 19

Fig. 20

Fig. 21

Fig. 22

Fig. 23

Fig. 24

Fig. 25

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CH 195706
- US 5936412 A

- GB 2286247 A